# EUROPEAN PATENT APPLICATION

(11) **EP 2 720 262 A1**
(43) Date of publication of application: **16.04.2014**
(21) Application number: 11857976.2
(22) Date of filing: 07.06.2011
(51) Int. Cl.: H01L 23/473, H05K 7/20

(54) **COOLER**

(71) Applicant: TOYOTA JIDOSHA KABUSHIKI KAISHA, Toyota-shi, Aichi-ken, 471-8571 (JP)
(72) Inventor: TAKENAGA, Tomohiro, Aichi 4718571 (JP)
(74) Representative: Albutt, Anthony John
(86) International application number: PCT/JP2011/063048
(87) International publication number: WO 2012/169012

(57) **Abstract**

A cooler (4) includes a plate (10), a cooling case (20) having a coolant (40) flowing therein, and a plurality of wavy fins (30) having a raised curved portion (31) and a lowered curved portion (32) formed alternately on a side face in a flow direction of the coolant (40). In this cooler (4), the coolant (40) flows through between the raised curved portion (31) and the lowered curved portion (32) opposite to each other in a meandering manner. The raised curved portion (31) is provided with a bank (31x) creating a flow of coolant from the raised curved portion (31) toward the opposite lowered curved portion (32). With this bank (31x), a part (MS1) of a main stream (MS) of the coolant (40) can be mixed with the coolant (40) stagnating near the lowered curved portion (32), whereby the heat transfer coefficient of the wavy fins (30) can be improved. Thus, stagnation of the coolant (40) near the lowered curved portion (32) can be prevented, so that the cooler (4) can have enhanced cooling performance.

## Description

### Technical Field

The present invention relates to a cooler in which a coolant flows along wavy fins arranged between a plate and a cooling case, and more particularly to a cooler with improved cooling performance.

### Background Art

In hybrid electric vehicles or the like, an inverter device (power conversion device) performs power conversion. The inverter device having a semiconductor device mounted therein is equipped with a cooler for cooling the heat generated by switching the semiconductor device. The amount of heat the semiconductor device generates has been increasing since such an inverter device is required to be small and lightweight and yet to provide high power output. Accordingly, a cooler with improved cooling performance (heat transfer coefficient) to keep stable operation of the inverter device is being sought after.

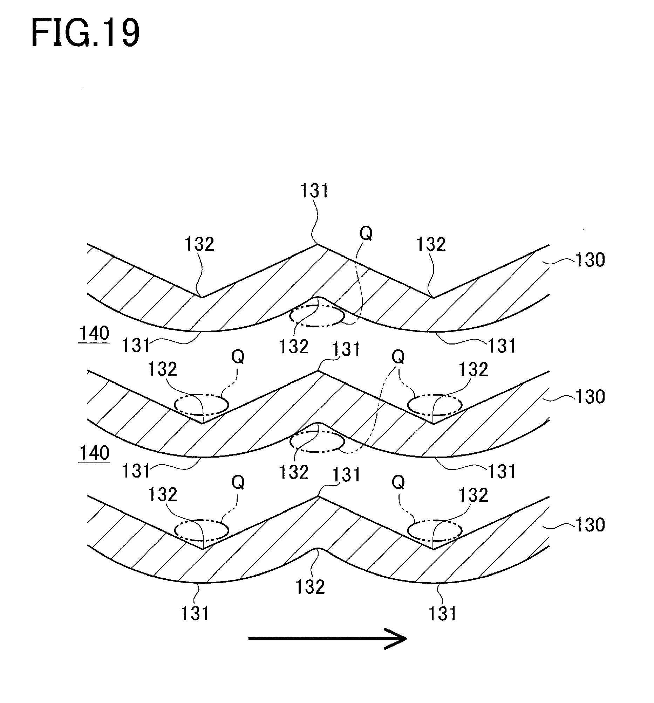

Patent Literature 1 specified below, for example, describes a cooler with improved cooling performance. The cooler described in Patent Literature 1 specified below includes a plate connected to a semiconductor device and a cooling case covered with the plate and containing a coolant flowing therein. To the plate are connected, as shown in FIG. 19, a plurality of wavy fins 130 extending in a flow direction (direction indicated by an arrow in FIG. 19) in which coolant 140 flows, the wavy fins 130 each having raised curved portions 131 and lowered curved portions 132 formed alternately in the flow direction on both sides thereof. The coolant 140 thus flows through between the raised curved portions 131 and lowered curved portions 132 opposite to each other in a meandering manner. This helps to create turbulence more easily and results in improved cooling performance.

### Citation List

### Patent Literature

[Patent Literature 1] JP 2008-186820 A

### Summary of Invention

### Technical Problem

The cooler described above had the following problem. Namely, the coolant 140 generally tends to flow straight, because of which the coolant 140 does not flow smoothly near the lowered curved portions 132 (parts Q indicated by imaginary lines in FIG. 19) when the coolant 140 passes through between the raised curved portions 131 and the lowered curved portions 132 opposite to each other as shown in FIG. 19. In other words, the flow of coolant 140 can hardly bend along the lowered curved portion 132. This led to stagnation (stagnation points) of the coolant 140 near the lowered curved portions 132, resulting in the cooling function of the coolant 140 not being fully exploited.

The present invention has been devised to solve the above-described problem and it is an object of the invention to provide a cooler that prevents stagnation of coolant near lowered curved portions to improve the cooling performance.

### Solution to Problem

(1) A cooler according to an aspect of the present invention includes a plate connected to a semiconductor device, a cooling case covered with the plate and having a coolant flowing therein, and wavy fins connected to the plate, each wavy fin having a raised curved portion and a lowered curved portion formed alternately on a side face of the wavy fin in a flow direction of the coolant, the coolant flowing through between the raised curved portion and lowered curved portion opposite to each other in a meandering manner, wherein the raised curved portion is provided with a stagnation preventing member for creating a flow of coolant from the raised curved portion toward an opposite lowered curved portion.
(2) In the cooler according to the above-described aspect of the present invention, the stagnation preventing member is provided preferably at a base portion of the raised curved portion on a semiconductor device side in a thickness direction of the wavy fins.
(3) In the cooler according to the above-described aspect of the present invention, the stagnation preventing member is preferably a tapered bank tapering toward a bottom wall of the cooling case.
(4) In the cooler according to the above-described aspect of the present invention, the stagnation preventing member may be a protrusion protruding from the raised curved portion toward the opposite lowered curved portion.
(5) In the cooler according to the above-described aspect of the present invention, a second stagnation preventing member for creating a flow of coolant from the raised curved portion toward the opposite lowered curved portion may be provided, the second stagnation preventing member being positioned at a distal portion of the raised curved portion on a side of the bottom wall of the cooling case in a thickness direction of the wavy fins.

### Advantageous Effects of Invention

The advantageous effects of the cooler will be described.

With the configuration (1), the stagnation preventing member creates a flow of coolant from the raised curved portion toward an opposite lowered curved portion. Thereby, the main stream of the coolant that tends to flow straight can be mixed with the coolant stagnating near the lowered curved portion, whereby the heat transfer coefficient of the wavy fins can be improved. Thus, stagnation of the coolant near the lowered curved portion can be prevented, so that the cooler can have enhanced cooling performance.

With the configuration (2), there is created a flow of the coolant from the base portion of the raised curved portion on the semiconductor device side toward the opposite lowered curved portion. Thereby, the coolant is disturbed near the base portions of the wavy fins where the temperature is relatively high. Therefore, the heat transfer coefficient of the wavy fins can be effectively improved. Moreover, by providing the stagnation preventing member only at the base portion, pressure fluctuations of the coolant caused by the stagnation preventing member can be reduced and pressure loss increase of the cooler can be kept small.

With the configuration (3), the tapered bank creates a flow of the coolant from the bank toward the bottom wall of the cooling case in addition to the flow of coolant from the bank toward the lowered curved portion. Therefore, the coolant can be disturbed largely near the bank, so that the heat exchange rate of the wavy fins can be effectively improved.

With the configuration (4), the stagnation preventing member is a protrusion, i.e., the stagnation preventing member can be provided with a very simple configuration. The protrusion can be configured small, so that pressure fluctuations of the coolant caused by the protrusion are reduced, and there will be almost no increase in the pressure loss in the cooler.

With the configuration (5), the stagnation preventing member and the second stagnation preventing member create flow of the coolant from the raised curved portion toward the opposite lowered curved portion. Thereby, the main stream of the coolant that tends to flow straight can be mixed substantially with the coolant stagnating near the lowered curved portion, whereby the heat transfer coefficient of the wavy fins can be largely improved.

### Brief Description of Drawings

FIG. 1 shows an overall configuration diagram of an inverter device;
FIG. 2 shows a longitudinal end view of a cooler in FIG. 1;
FIG. 3 shows a perspective view of wavy fins in FIG. 2;
FIG. 4 shows a plan view of the wavy fins in FIG. 3;
FIG. 5 shows an end view of the cooler taken along a line V-V in FIG. 4;
FIG. 6 shows an end view of the cooler taken along a line W-W in FIG. 4;
FIG. 7 shows an enlarged view of a part X in FIG. 5;
FIG. 8 shows a schematic view illustrating flow of coolant when there are no banks provided on a raised curved portion;
FIG. 9 shows a schematic view illustrating the flow of the coolant when there are banks provided on the raised curved portion;
FIG. 10 is a schematic graph showing a relationship between a distance from a base portion and a temperature of the wavy fins and the coolant when there are no banks provided on a base portion;
FIG. 11 is a schematic graph showing a relationship between the distance from the base portion and the temperature of the wavy fins and the coolant when there are banks provided on the base portion;
FIG. 12 is a diagram indicating measured values of the heat transfer coefficient of the wavy fins and the pressure loss of the cooler when the coolant flows in the cooler;
FIG. 13 is an end view of the cooler corresponding to FIG. 2 in a case where a sheet member is interposed between an end portion of the wavy fins and a bottom wall of the cooling case;
FIG. 14 is a schematic view illustrating the flow of the coolant when there are protrusions provided on the raised curved portion in a second embodiment;
FIG. 15 is an enlarged view of a part Y in FIG. 14;
FIG. 16 is an end view corresponding to FIG. 5, illustrating a second bank is provided on a bottom wall of a cooling case in a third embodiment;
FIG. 17 is an enlarged view of a part Z in FIG. 16;
FIG. 18 is an end view corresponding to FIG. 5, illustrating a second bank is provided on a sheet member in a forth embodiment; and
FIG. 19 is an explanatory view explaining how stagnation of coolant is created near a lowered curved portion of a wavy fin in a prior art.

### Description of Embodiments

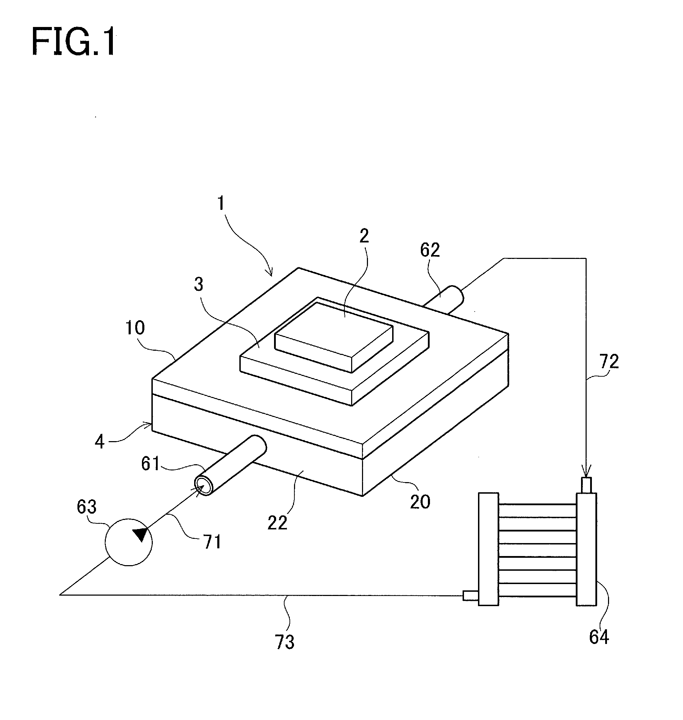

The cooler according to the present invention will be hereinafter described with reference to the drawings. FIG. 1 is an overall configuration diagram schematically illustrating an inverter device 1 to which a cooler 4 is applied. This inverter device 1 is mounted in hybrid electric vehicles or electric vehicles, for example, and includes a semiconductor device 2, an insulating substrate 3, and the cooler 4, as shown in FIG. 1.

The semiconductor device 2 is an electronic component that forms an inverter circuit. This semiconductor device 2 is, for example, an IGBT or a diode and it is a heat generating element that generates heat by its switching operation. The semiconductor device 2 is joined onto the insulating substrate 3 by soldering.

The insulating substrate 3 provides electrical insulation between the semiconductor device 2 and the cooler 4. This insulating substrate 3 is, for example, a DBA substrate. The insulating substrate 3 is joined onto the cooler 4 by brazing. Here, although the cooler 4 includes one each semiconductor device 2 and insulating substrate 3 mounted thereon, there may be provided a plurality of them.

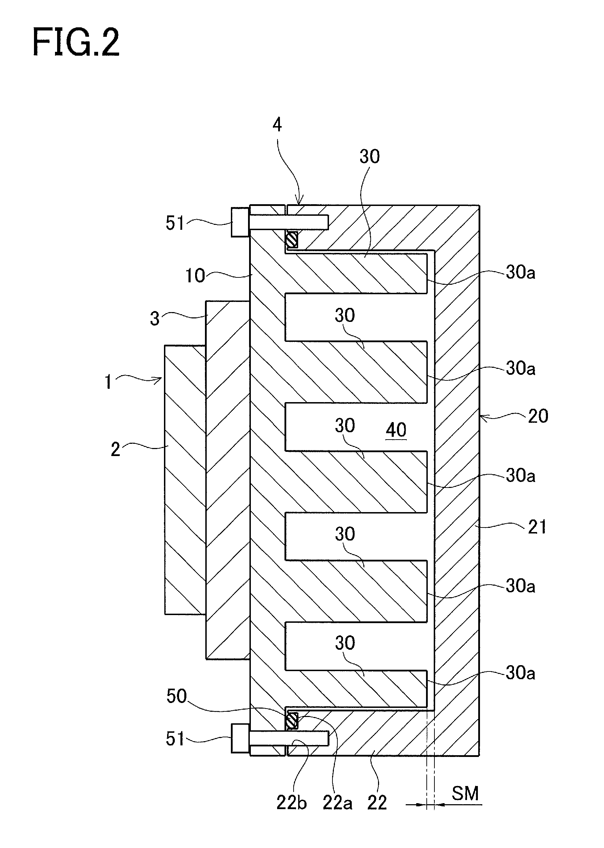

The cooler 4 cools the heat generated by switching the semiconductor device 2 with a coolant 40 flowing inside. FIG. 2 is a longitudinal end view of the cooler 4 shown in FIG. 1; it is viewed in a direction in which the coolant flows. The cooler 4 includes a plate 10, a cooling case 20, and a plurality of wavy fins 30 as shown in FIG. 2.

The plate 10 functions as a lid member to the cooling case 20. The plate 10 is formed of aluminum, for example, which has good thermal conductivity. This plate 10 is planar, and the wavy fins 30 are each integrally connected to the plate 10 at one side facing the cooling case 20. The plate 10 is connected to the semiconductor device 2 via the insulating substrate 3.

The cooling case 20 is a case for the coolant 40 to flow inside. The cooling case 20 is formed of aluminum, for example, which has good thermal conductivity. This cooling case 20 is an open-end box as shown in FIG. 2 and includes a rectangular bottom wall 21 and side walls 22 extending vertically upwards in FIG. 2 from peripheral edges of this bottom wall 21.

The side walls 22 are formed with a recess 22a for an O-ring 50 to be fitted in, and insertion holes 22b for bolts 51 to be threaded in as shown in FIG. 2. Thus, with the O-rings 50 fitted into the recesses 22a in the side walls 22, the plate 10 is assembled to the side walls 22 of the cooling case 20 by the bolts 51. The plate 10 and the cooling case 20 may be assembled together by welding instead.

An inlet pipe 61 is connected to the side wall 22 on the front side in FIG. 1, while an outlet pipe 62 is connected to the side wall 22 on the back side in FIG. 1. The inlet pipe 61 is connected to a discharge pump 63 via a discharge flow path 71. The outlet pipe 62 is connected to a heat exchanger 64 via a return flow path 72. The discharge pump 63 and the heat exchanger 64 are connected to each other via an intake flow path 73.

Thus the coolant 40 flows into the cooler 4 through the inlet pipe 61 after being discharged from the discharge pump 63. The coolant 40 then flows inside the cooling case 20 as being in contact with respective wavy fins 30. At this time, the heat from the respective wavy fins 30 is absorbed by the coolant 40 and warms up the coolant 40. After that, the coolant 40 is sent out through the outlet pipe 62 to the heat exchanger 64. Thereby, the coolant 40 is cooled down by heat dissipation to the air in the heat exchanger 64, and the cooled coolant 40 is returned to the discharge pump 63.

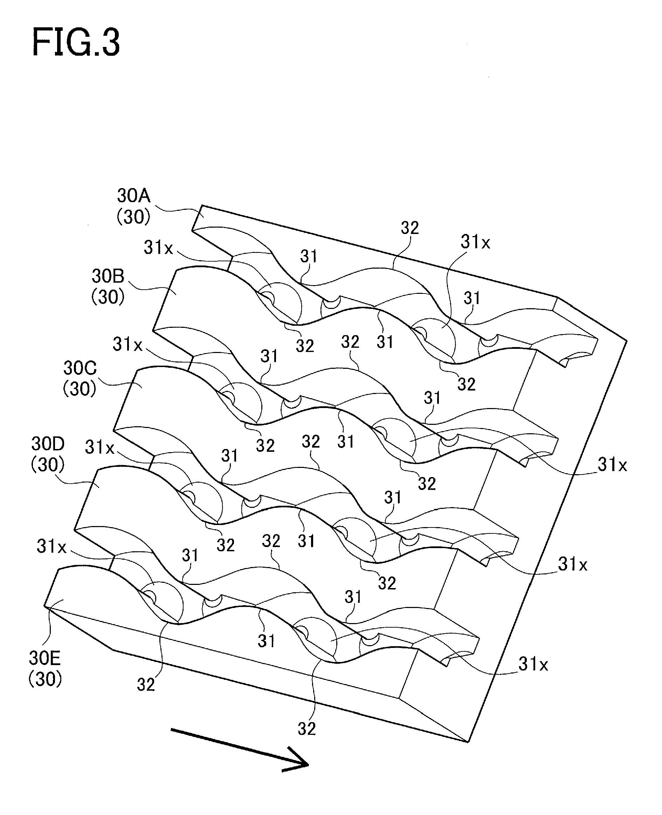

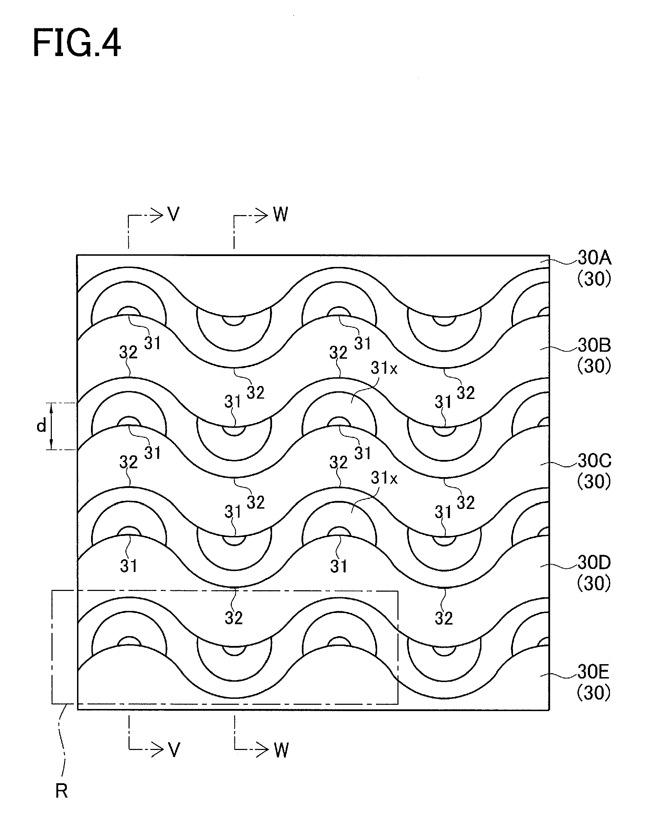

The coolant 40 circulates through the cooler 4 in this way to cool down the heat conducted from the semiconductor device 2 to the wavy fins 30. The coolant 40 may be, as in this embodiment, a liquid such as LLC, but not limited to liquids and may be gas such as air. FIG. 3 is a perspective view of the wavy fins 30 shown in FIG. 2. FIG. 4 is a plan view of the wavy fins 30 shown in FIG. 3.

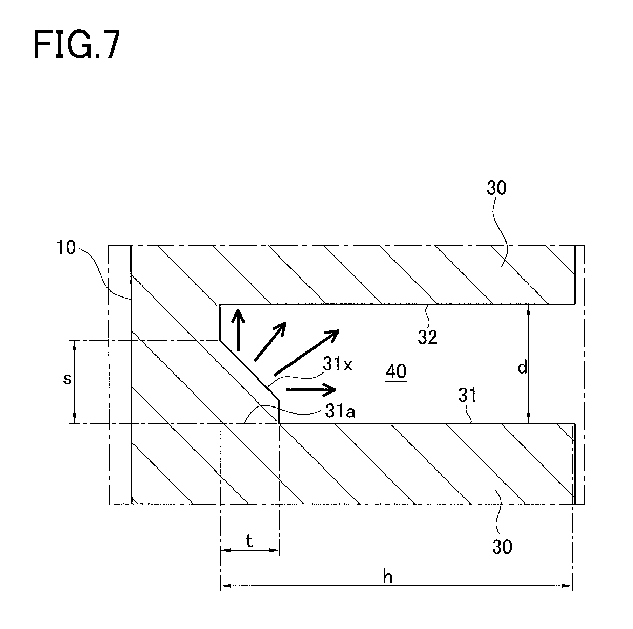

As shown in FIGs. 3 and 4, the wavy fins 30 extend in a flow direction in which the coolant 40 flows (direction indicated by an arrow in FIGs. 3 and 4), and there are five such fins formed on the underside of the plate 10. The number of the wavy fins 30 is not limited to five and may be changed as required. These wavy fins 30 are integrally molded on the plate 10 by casting. Each wavy fin 30 winds in a meandering shape so as to increase the contact area with the coolant 40 and is spaced apart by about 1 mm from an adjacent wavy fin 30 in a direction orthogonal to the flow direction. Dimension h in the thickness direction (see FIG. 7) of each wavy fin 30 is about 3 mm which is slightly smaller than the dimension in the height direction of the side walls 22. Flow paths for the coolant 40 are thus formed inside the cooling case 20, so that the coolant 40 flows along the flow direction, meandering through between the adjacent wavy fins 30.

In this embodiment, the distance (flow path width) d between adjacent wavy fins 30 is constant (about 1 mm) at any point in the flow direction as shown in FIG. 4. This is for reducing a difference in pressure of the coolant 40 at an inlet side (left side in FIG. 4) of the wavy fins 30 and an outlet side (right side in FIG. 4) of the wavy fins 30 so as to reduce pressure loss of the cooler 4. Namely, if the distance d between adjacent wavy fins 30 varied in the flow direction, there would be large fluctuations in the coolant 40 pressure at the inlet and outlet sides of the wavy fins 30, which would increase pressure loss of the cooler 4. A large pressure loss in the cooler 4 would necessitate large driving force to drive the discharge pump 63, and such driving energy would be wasted.

Here, the five wavy fins 30 in FIGs. 3 and 4 will be denoted by 30A, 30B, 30C, 30D, and 30E in order in the direction orthogonal to the flow direction. The wavy fins 30A and 30E at both ends have a flat surface formed on one side. This is because one side of the wavy fins 30A and 30E faces the side wall 22 of the cooling case 20. The other side of the wavy fins 30A and 30E, on the other hand, is formed with raised curved portions 31 and lowered curved portions 32 alternately in the flow direction. The wavy fins 30B, 30C, and 30E are also formed on both sides with the raised curved portions 31 and lowered curved portions 32 alternately in the flow direction. Thus the raised curved portions 31 and lowered curved portions 32 of the adjacent wavy fins 30 face each other with spaced apart by about 1 mm.

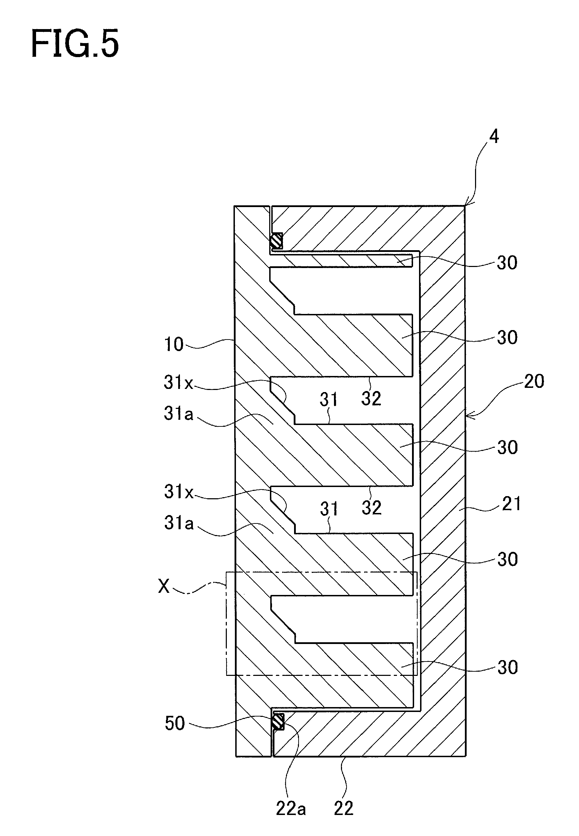

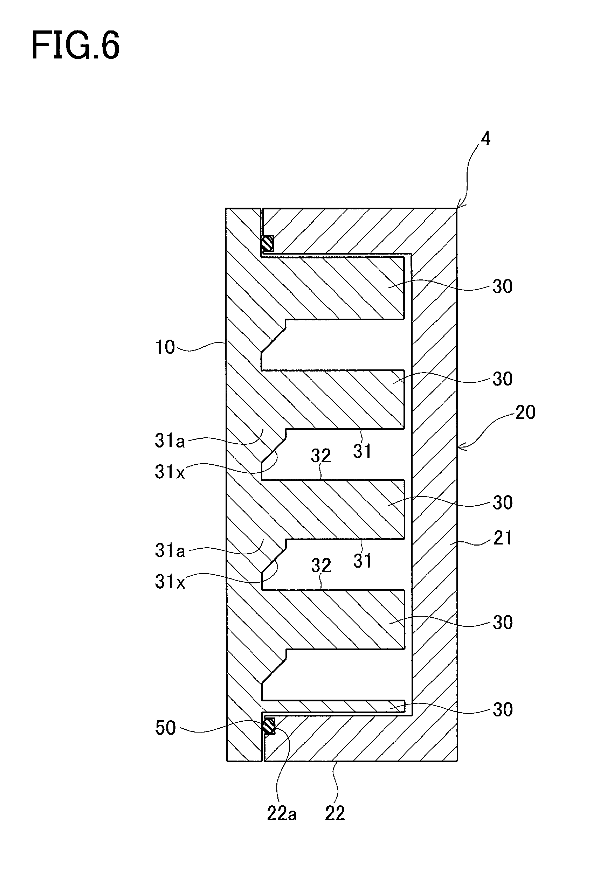

In this embodiment, as shown in FIGs. 3 and 4, the raised curved portions 31 of each wavy fin 30 are each formed with a bank 31x. Each bank 31x prevents creation of stagnation (stagnation points) of the coolant 40 in vicinity of each lowered curved portion 32. These banks 31x are integrally formed with the respective raised curved portions 31 by casting. This bank 31x is the stagnation preventing member of the present invention. Hereinafter the bank 31x will be described in detail. FIG. 5 is an end view of the cooler 4 taken along a line V-V shown in FIG. 4. FIG. 6 is an end view of the cooler 4 taken along a line W-W shown in FIG. 4.

The bank 31x has a shape like a generally vertical half of a taper as shown in FIGs. 5 and 6, tapering toward the bottom wall 21 of the cooling case 20. The tip portion of this bank 31 is not pointed but has a flat surface parallel to the bottom wall 21. The tip shape of the bank 31 is not limited to the flat shape and may be changed as required, and it may be pointed.

FIG. 7 is an enlarged view of a part X shown in FIG. 5. As shown in FIG. 7, the dimension s in the width direction (vertical direction in FIG. 7) of the bank 31x is about 0.7 mm, and the dimension t in the height direction (lateral direction in FIG. 7) of the bank 31x is about 0.5 mm. This bank 31x thus generates flows of the coolant 40 as indicated by arrows in FIG. 7. Namely, there are created flows of the coolant 40 from the raised curved portion 31 toward the opposite lowered curved portion 32.

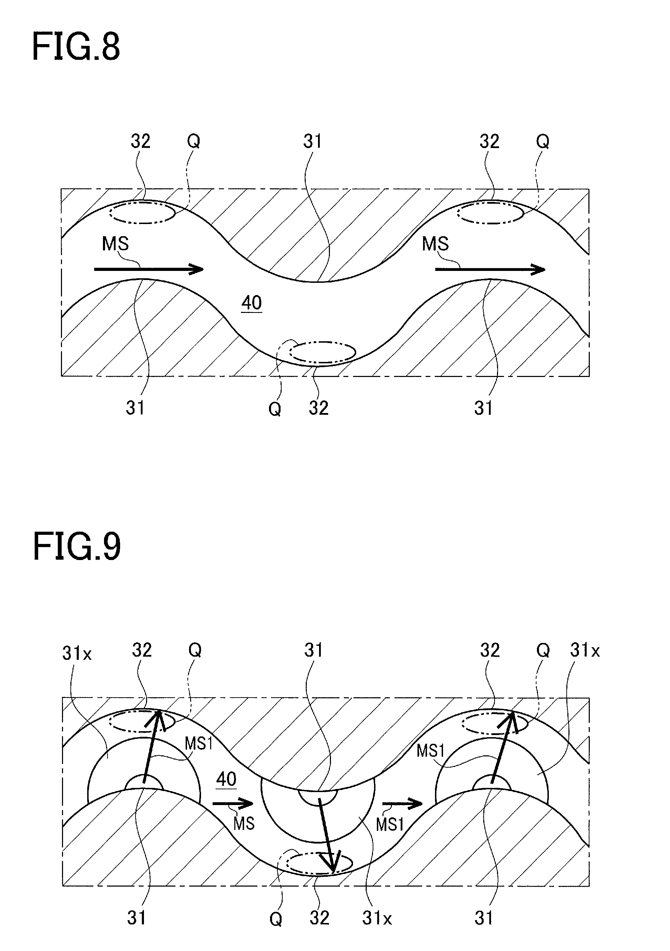

Next, the advantageous effects of the bank 31x will be explained using FIGs. 8 and 9. FIG. 8 is a schematic diagram illustrating flow of the coolant 40 when there are no banks 31x provided on the raised curved portions 31. FIG. 9 is a schematic diagram illustrating the flow of the coolant 40 when there are banks 31x provided on the raised curved portions 31. FIG. 9 is an enlarged view of a part R shown in FIG. 4.

When there are no banks 31x as shown in FIG. 8, the coolant 40 does not flow smoothly near the lowered curved portions 32 (parts Q indicated by imaginary lines in FIG. 8) when the coolant 40 passes through between the raised curved portions 31 and the lowered curved portions 32 opposite to each other. In other words, since the coolant 40 generally flows straight, the main stream MS that tends to flow straight does not easily bend along the lowered curved portions 32. For this reason, there are created some stagnation (stagnation points) of the coolant 40 near the lowered curved portions 32, and the cooling function of the coolant 40 cannot be fully exploited.

On the other hand, when there are banks 31x provided as shown in FIG. 9, part MS1 of the main stream MS flows toward the lowered curved portions 32 when the coolant 40 passes through between the raised curved portions 31 and the lowered curved portions 32 opposite to each other. Therefore, the part MS1 of the main stream MS mixes with the coolant 40 located near the lowered curved portions 32. As a result, no stagnation of the coolant 40 occurs near the lowered curved portions 32, so that the cooling function of the coolant 40 is fully exploited.

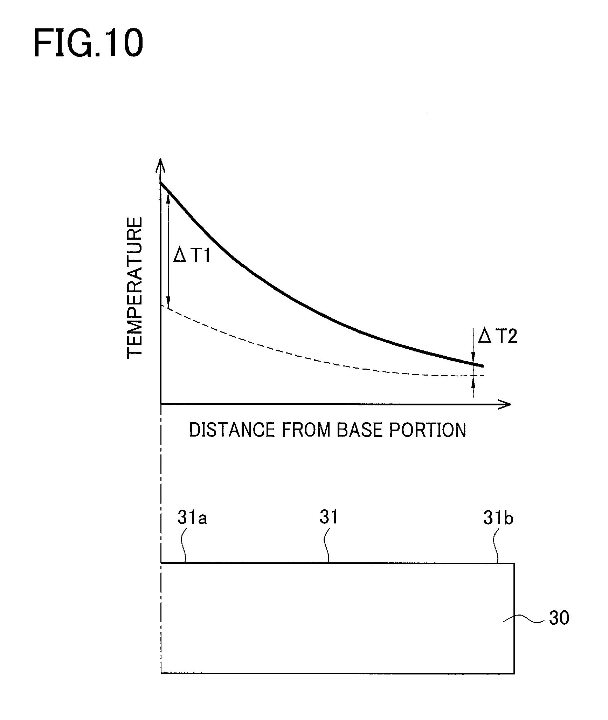

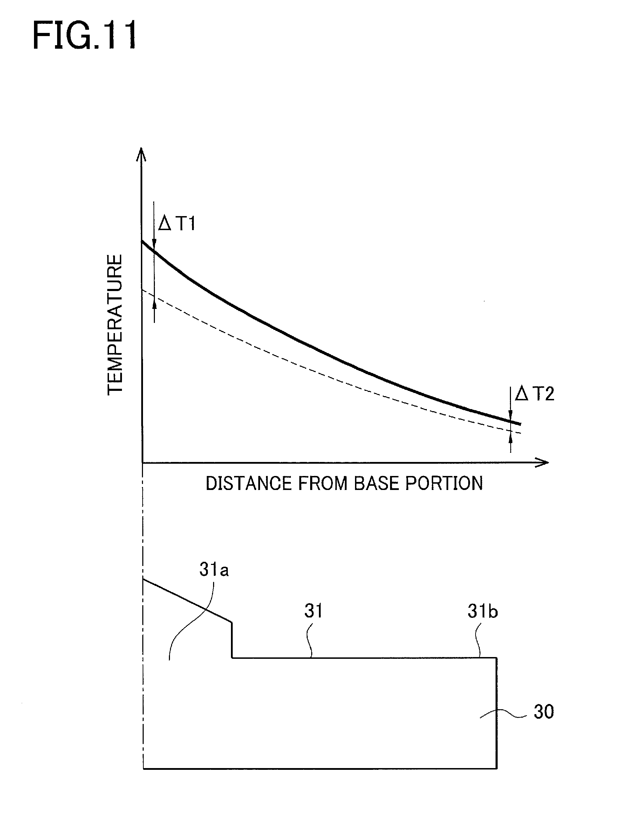

The bank 31x of this embodiment is provided at a base portion 31a on the semiconductor device 2 side (left side in FIG. 5 to FIG. 7) of the raised curved portion 31 in the thickness direction (lateral direction in FIGs. 5 to 7) of the wavy fin 30, as shown in FIGs. 5 to 7. The reason why the bank 31x is provided at the base portion 31a will be explained using FIGs. 10 and 11.

FIG. 10 is a schematic graph showing the relationship between the distance from the base portion 31 a and the temperature of the wavy fins 30 and the coolant 40 when there are no banks 31x provided on the base portions 31a. On the other hand, FIG. 11 is a schematic graph showing the relationship between the distance from the base portion 31a and the temperature of the wavy fins 30 and the coolant 40 when there are banks 31x provided on the base portions 31a. Here, in FIGs. 10 and 11, the solid line represents the temperature of the wavy fins 30, while the broken line represents the temperature of the coolant 40. A portion of the raised curved portion 31 located on the side of the bottom wall 21 (right side in FIGs. 10 and 11) of the cooling case 20 in the thickness direction of the wavy fin 30 will be referred to as a distal portion 31b.

As shown in FIG. 10, when there are no banks 31x provided on the base portions 31a, the temperature difference ΔT1 between the base portions 31a and the coolant 40 is large, while the temperature difference ΔT2 between the distal portions 31b and the coolant 40 is small. This is because the base portions 31a are formed closer to the semiconductor device 2 as a heat generating element than the distal portions 31b and tend to be hot, because of which the coolant 40 located near the base portions 31a cannot sufficiently absorb the heat of the hot base portions 31a. Thus the temperature difference ΔT1 is large, resulting in a low heat transfer coefficient of the wavy fins 30.

In contrast, as shown in FIG. 11, when there are banks 31x provided on the base portions 31a, the temperature difference ΔT1 is small. This is because the coolant 40 located near the base portions 31a is disturbed because of the banks 31x and absorbs the heat of the hot base portions 31a sufficiently. Thus, by providing banks 31x on the base portions 31a, the temperature difference ΔT1 is made small, leading to a high heat transfer coefficient of the wavy fins 30. Namely, when the banks 31x are provided on the base portions 31a, the temperature difference between the wavy fins 30 and the coolant 40 is made smaller than when the banks 31x are provided on other portions than the base portions 31a, whereby the heat transfer coefficient of the wavy fins 30 can be effectively improved.

In this embodiment, the banks 31x are provided only on the base portions 31a as shown in FIGs. 5 to 7, and not on other portions than the base portions 31a. This is based on the following reason. If the banks 31x are also provided on portions than the base portions 31a, the main stream MS (see FIG. 9) of the coolant 40 would be largely obstructed. This would result in large fluctuations in the coolant 40 pressure at the inlet and outlet sides of the wavy fins 30, which would increase pressure loss of the cooler 4. Thus, providing the banks 31x only on the base portions 31a will improve the heat transfer coefficient of the wavy fins 30 as well as reduce an increase in pressure loss of the cooler 4.

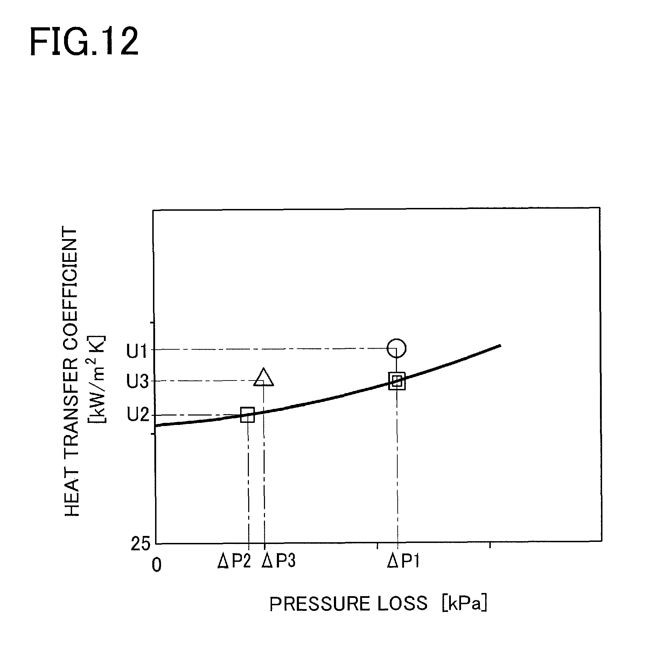

Next, test results of the heat transfer coefficient of the wavy fins and the pressure loss of the cooler will be described using FIG. 12. FIG. 12 is a diagram showing actual measurements (measured values) of the heat transfer coefficient of the wavy fins and the pressure loss of the cooler when the coolant is flowing inside the cooler. The measurements were obtained in this test under conditions that the coolant 40 is discharged from the discharge pump 63 at a predetermined constant rate (L/min) and there is a small gap SM formed between end portions 30a (see FIG. 2) of the wavy fins 30 and the bottom wall 21 of the cooling case 20.

In FIG. 12, the circle indicates the measurement when there are banks 31x provided as in this embodiment (see FIG. 9) while the square indicates the measurement when there are no banks 31x (see FIG. 8). At the point indicated by the circle in FIG. 12, the heat transfer coefficient is U1 and the pressure loss is ΔP1. At the point indicated by the square in FIG. 12, the heat transfer coefficient is U2 and the pressure loss is ΔP2. U1 is higher than U2 by about 9%, indicating that the heat transfer coefficient is increased by providing the banks 31x. ΔP1 is larger than ΔP2, indicating that the pressure loss is increased by providing the banks 31x.

Here, the heat transfer coefficient and the pressure loss are proportional to the flow rate and speed of the coolant 40. Namely, the flow rate and speed of the coolant 40 have a relationship to the heat transfer coefficient and the pressure loss such that the larger the former, the larger the latter. Therefore, a comparison of the level of the heat transfer coefficient between a case where there are banks 31x provided and another case where there are no banks 31x needs to be made under a condition that the pressure loss is the same. The double square in FIG. 12 indicates the measurement when the pressure loss is made to ΔP1 by increasing the flow rate and speed of the coolant 40 when there are no banks 31x based on the assumption above. The solid line shown in FIG. 12 indicates changes in the heat transfer coefficient and the pressure loss with the change in the flow rate and speed of the coolant 40 when there are no banks 31x provided.

As is clear from a comparison between the circle and the double square indicated in FIG. 12, when the pressure loss is ΔP1, the heat transfer coefficient when there are banks 31x provided is higher than the heat transfer coefficient when there are no banks 31x provided. Accordingly, it can be considered that while providing the banks 31x increases the pressure loss, it can also largely improve the heat transfer coefficient. More specifically, it was confirmed that the temperature at the base portions 31a of the wavy fins 30 was reduced by about 5°C by providing the banks 31x.

In this embodiment, as shown in FIG. 2, there is a small gap SM formed between the end portions 30a of the wavy fins 30 and the bottom wall 21 of the cooling case 20. This gap SM is about 0.3 mm, for example, which is shown exaggerated in FIG. 2. If the coolant 40 flows into this gap SM, the flow speed of the main stream MS of the coolant 40 reduces, which in turn reduces the heat transfer coefficient of the wavy fins 30. However, in the cooler 4 of this embodiment, since the heat transfer coefficient of the wavy fins 30 is effectively improved by providing the banks 31x at the base portions 31a as described above, this reduction in the heat transfer coefficient of the wavy fins 30 caused by the formation of the gap SM does not become a problem.

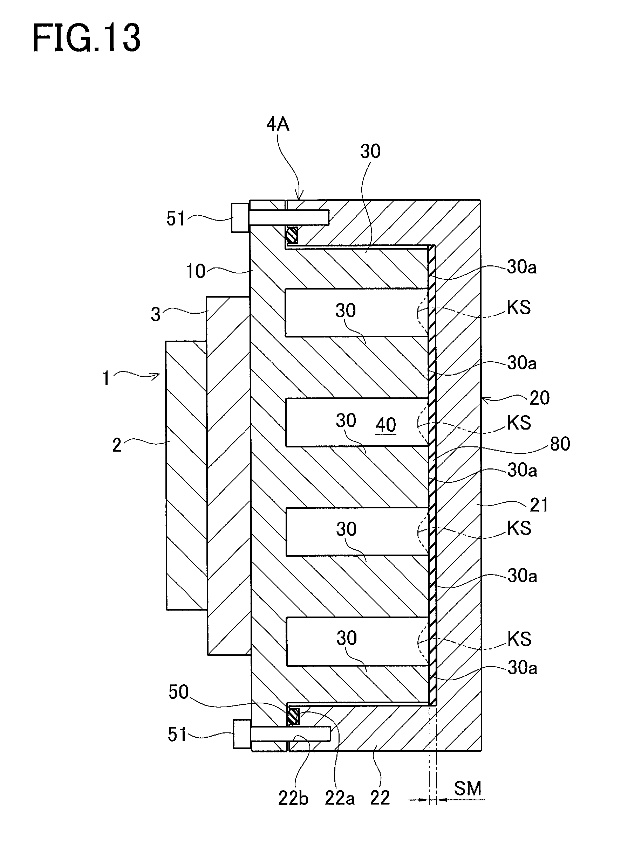

One possibility here would be to interpose a sheet member 80 made of an elastic material (such as rubber or resin) between the end portions 30a of the wavy fins 30 and the bottom wall 21 of the cooling case 20 as shown in FIG. 13 in order to prevent the coolant 40 from flowing into the gap SM. The cost, however, would be higher with the cooler 4A shown in FIG. 13 because of the sheet member 80 being added as another component, as compared to the cooler 4 of this embodiment.

Moreover, with the cooler 4A shown in FIG. 13, there is a risk that the end portions 30a of the wavy fins 30 are pressed to the sheet member 80 when the plate 10 with the wavy fins 30 is assembled to the cooling case 20, so that the sheet member 80 may enter in a space between adjacent wavy fins 30 as indicated by the imaginary lines KS in FIG. 13. In this case, the pressure loss increases as compared to the cooler 4 of this embodiment since the space for the coolant 40 to flow in is reduced.

In short, even without the sheet member 80 to be fitted in the gap SM, the heat transfer coefficient of the wavy fins 30 can be effectively improved by providing the banks 31x at the base portions 31a according to the cooler 4 of the present embodiment. By not providing the sheet member 80, the cooler 4 can be configured less expensively, and pressure loss increase in the cooler 4 is reduced.

The advantageous effects of the cooler 4 of the first embodiment will be described. In this cooler 4, as shown in FIG. 9, the banks 31x create flows of the coolant 40 from the raised curved portions 31 toward the opposite lowered curved portions 32. Thereby, the part MS1 of the main stream MS of the coolant 40 can be mixed with the coolant 40 stagnating near the lowered curved portions 32, whereby the heat transfer coefficient of the wavy fins 30 can be improved. Thus, stagnation of the coolant 40 near the lowered curved portions 32 can be prevented, so that the cooler 4 can have enhanced cooling performance.

In the cooler 4 of the first embodiment, as shown in FIG. 7, the banks 31x provided at the base portions 31a create flows of coolant from the base portions 31a of the raised curved portions 31 toward the opposite lowered curved portions 32. Thereby, the coolant 40 is disturbed near the base portions 31a of the wavy fins 30 where the temperature is relatively high. Therefore the heat transfer coefficient of the wavy fins 30 can be effectively improved. Moreover, since the banks 31x are provided only at the base portions 31a, pressure fluctuations of the coolant 40 caused by the banks 31x can be reduced and pressure loss increase in the cooler 4 can be kept small.

In the cooler 4 of the first embodiment, as shown in FIG. 7, the tapered banks 31x also create flows of the coolant 40 from the banks 31x toward the bottom wall 21 of the cooling case 20, in addition to the flows of the coolant 40 from the banks 31x toward the lowered curved portions 32. Therefore, the coolant 40 is disturbed largely near the banks 31x, so that the heat exchange rate of the wavy fins 30 can be effectively improved.

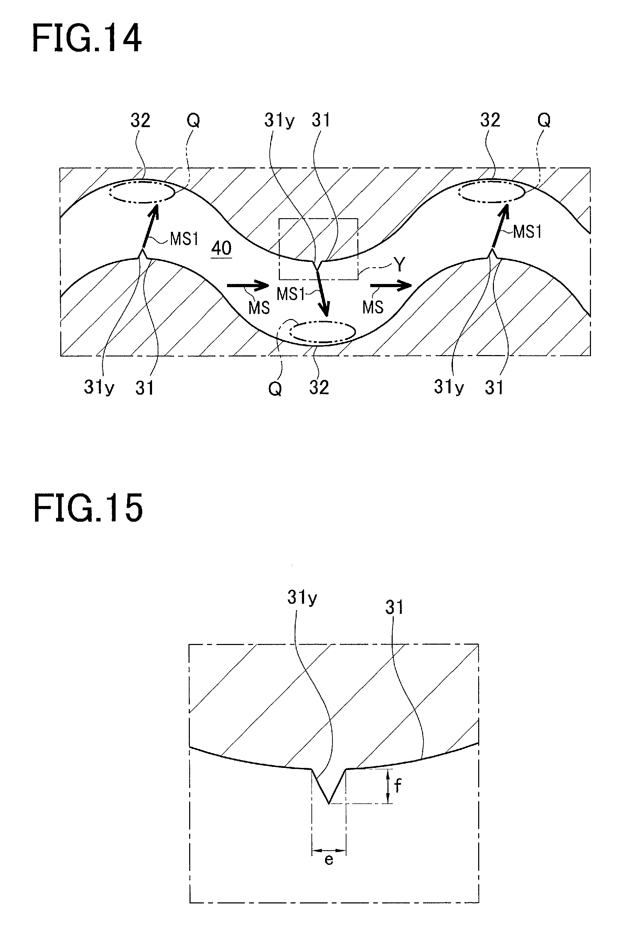

Next, a second embodiment will be described using FIGs. 14 and 15. In the second embodiment, protrusions 31y are provided in the raised curved portions 31 instead of the banks 31x of the first embodiment. FIG. 14 is a schematic view illustrating the flow of the coolant 40 when there are protrusions 31y provided on the raised curved portions 31.

The protrusions 31y prevent creation of stagnation (stagnation point) of the coolant 40 near the lowered curved portions 32. This protrusion 31y is in a triangular column shape as shown in FIG. 14 and protrudes from the raised curved portion 31 toward the opposite lowered curved portion 32. This protrusion 31y is provided at the base portion 31a of the raised curved portion 31 and integrally formed with the raised curved portion 31 by casting. Alternately, the protrusions 31y may be separate members from the wavy fins 30 and may be joined to the raised curved portions 31 by welding or bonding.

When the coolant 40 passes through between the raised curved portion 31 and the lowered curved portion 32 opposite to each other, as shown in FIG. 14, the protrusion 31 y changes the direction of the part MS1 of the main stream MS, and thereby the part MS 1 of the main stream MS flows toward the lowered curved portion 32. Thus, the part MS1 of the main stream MS is mixed with the coolant 40 located near the lowered curved portion 32 (part Q). As a result, no stagnation of the coolant 40 occurs near the lowered curved portions 32, so that the cooling function of the coolant 40 is fully exploited.

FIG. 15 is an enlarged view of a part Y shown in FIG. 14. As shown in FIG. 15, the dimension e in the width direction (lateral direction in FIG. 15) of the protrusion 31y is about 0.1 mm, and the dimension f of the protruding distance of the protrusion 31y from the surface of the raised curved portion 31 is about 0.1 mm. The dimension in the height direction (direction orthogonal to the paper plane of FIG. 15) of the protrusion 31y is about 0.1 mm. That is, the protrusions 31y are substantially smaller than the banks 31x of the first embodiment. Since other configurations of the second embodiment are similar to the configurations of the first embodiment, the description will be omitted.

Since the protrusions 31y are very small as described above, the main stream MS of the coolant 40 is unlikely to be obstructed largely by the protrusions 31y. Therefore, the pressure fluctuations of the coolant 40 are smaller than that in the first embodiment and the pressure loss of the cooler can be made small. However, the amount of the coolant 40 made to flow toward the lowered curved portions 32 by the protrusions 31y is smaller than that of the coolant 40 made to flow toward the lowered curved portions 32 by the banks 31x in the first embodiment. Accordingly, the amount of the coolant 40 mixed near the lowered curved portions 32 is smaller than that in the first embodiment, because of which an increase in the heat transfer coefficient of the wavy fins 30 is accordingly small.

The triangle shown in FIG. 12 indicates the measurement in a test in which the protrusions 31y are provided. The measurement indicated by the triangle was obtained in the test under the same conditions as the tests in which the measurements were made when the banks 31x of the first embodiment are provided (circle in FIG. 12) and when the banks 31x are not provided (square in FIG. 12).

At the triangle in FIG. 12, the heat transfer coefficient is U3, which is higher than U2 by about 5%. This indicates that providing the protrusions 31y improves the heat transfer coefficient. However, it also indicates that, with the protrusions 31y, the increase in the heat transfer coefficient is smaller than when the banks 31x are provided.

At the triangle in FIG. 12, the pressure loss is ΔP3, which is slightly larger than ΔP2. This indicates that the pressure loss increase caused by the protrusions 31y is very small. It also indicates that, with the protrusions 31y, the pressure loss increase is sufficiently smaller than that of the case where the banks 31x are provided.

The advantageous effects of the second embodiment will be described. In the second embodiment, the stagnation preventing member is the protrusions 31y, i.e., the stagnation preventing member can be provided with a very simple configuration. Since the protrusions 31y are configured very small as shown in FIG. 15, pressure fluctuations of the coolant 40 caused by the protrusions 31y are reduced, so that there will be almost no increase in the pressure loss in the cooler. Since other advantageous effects of the second embodiment are similar to the advantageous effects of the first embodiment, the description will be omitted.

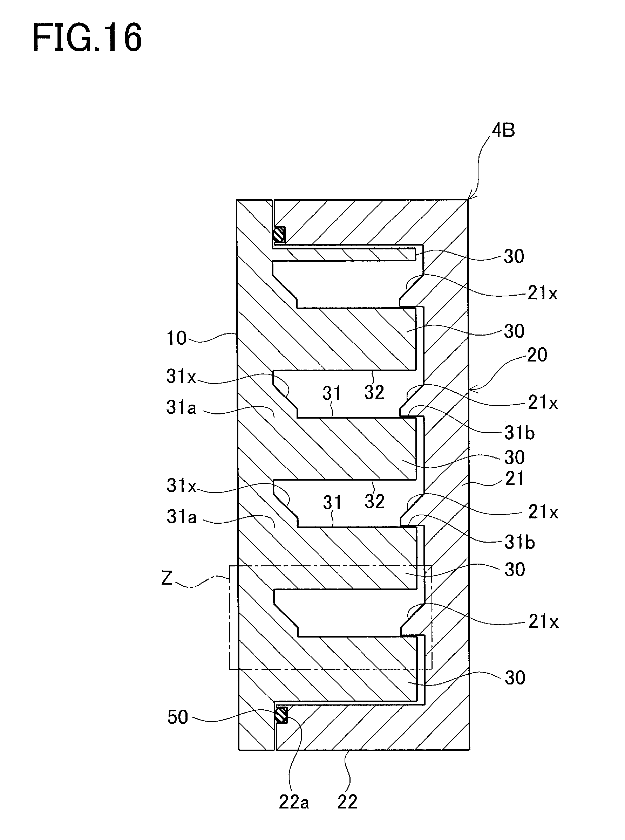

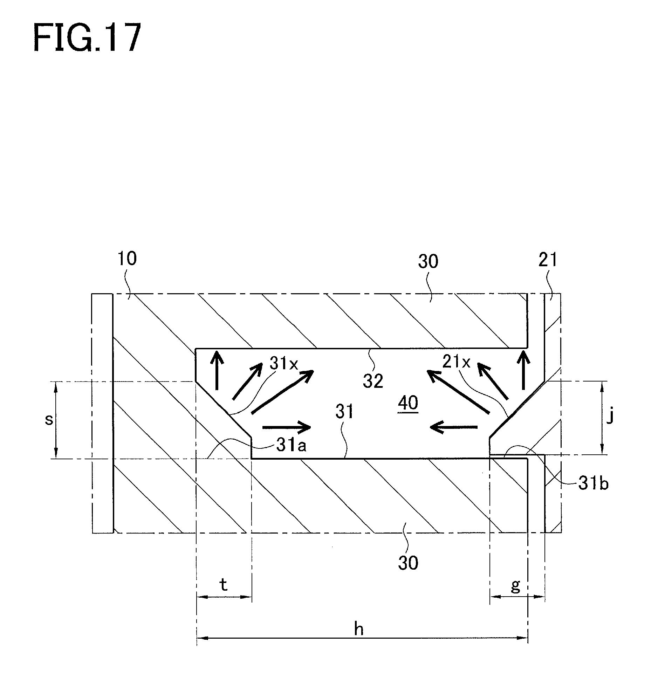

Next, a third embodiment will be described using FIGs. 16 and 17. In the third embodiment, second banks 21x are provided on the bottom wall 21 of the cooling case 20. FIG. 16 is an end view corresponding to FIG. 5 illustrating the second banks 21x provided on the bottom wall 21 of the cooling case 20.

As shown in FIG. 16, the banks 31x are each provided at the base portions 31a of the respective raised curved portions 31, as with the first embodiment. In the third embodiment, the second banks 21x are each located closer to distal portions 31b of respective raised curved portions 31 on the bottom wall 21 side (right side in FIG. 16) of the cooling case 20 in the thickness direction of the wavy fins 30, these second banks 21x being integrally formed to the bottom wall 21 of the cooling case 20. The second banks 21x prevent creation of stagnation (stagnation points) of the coolant 40 near the lowered curved portions 32, and correspond to the second stagnation preventing member of the present invention. FIG. 17 is an enlarged view of a part Z shown in FIG. 16.

The second bank 21x has a shape like a generally vertical half of a taper as shown in FIG. 17, tapering toward the plate 10 (left side of FIG. 17). A tip portion of this second bank 21x is not pointed but has a flat surface parallel to the bottom wall 21. The tip shape of the second bank 21x is not limited to the flat shape and may be changed as required, and it may be pointed.

The dimension j in the width direction (vertical direction in FIG. 17) of the second bank 21x is about 0.7 mm, and the dimension g in the height direction (lateral direction in FIG. 17) of the bank 21x is about 0.5 mm. This second bank 21x thus generates flows of the coolant 40 as indicated by arrows in FIG. 17. Namely, there are created flows of coolant from the distal portions 31b of the raised curved portions 31 toward the opposite lowered curved portions 32. Since other configurations of the third embodiment are similar to the configurations of the first embodiment, the description will be omitted.

The advantageous effects of the third embodiment will be described. In the third embodiment, as shown in FIG. 17, the banks 31x and the second banks 21x create flows of the coolant 40 from the raised curved portions 31 toward the opposite lowered curved portions 32. Thereby, the main stream MS of the coolant 40 that tends to flow straight can be mixed substantially with the coolant 40 stagnating near the lowered curved portions 32, whereby the heat transfer coefficient of the wavy fins 30 can be largely improved. Namely, the heat transfer coefficient of the wavy fins 30 can be increased more than the first embodiment.

However, the pressure fluctuations of the coolant 40 are large in the third embodiment since the space for the coolant 40 to flow in is reduced due to the second banks 21x. The pressure loss in the cooler 4B of the third embodiment is therefore larger than the pressure loss of the cooler 4 of the first embodiment. Since other advantageous effects of the third embodiment are similar to the advantageous effects of the first embodiment, the description will be omitted.

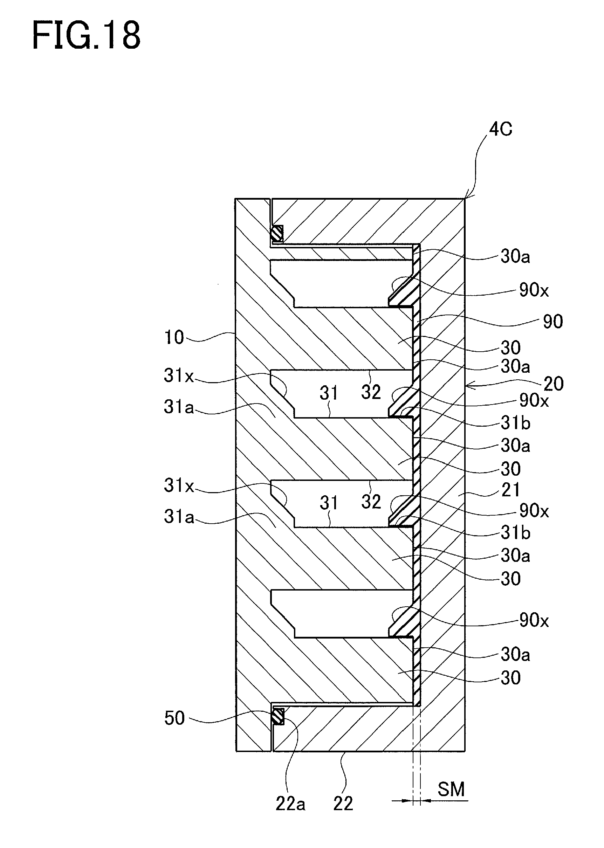

Next, a fourth embodiment will be described using FIG. 18. In the fourth embodiment, a sheet member 90 is fitted in the gap SM between the end portions 30a of the wavy fins 30 and the bottom wall 21 of the cooling case 20, and second banks 90x are provided to this sheet member 90. FIG. 18 is an end view corresponding to FIG. 5 illustrating the second banks 90x provided on the sheet member 90.

The flat plate-like sheet member 90 fills up the gap SM as shown in FIG. 18. This sheet member 90 prevents the coolant 40 from flowing into the gap SM. The sheet member 90 is made of an elastic material (such as rubber or resin) and bonded to the bottom wall 21 of the cooling case 20 before the plate 10 and the wavy fins 30 are assembled to the cooling case 20. The gap SM is about 0.3 mm, for example, and the sheet member 90 also has a thickness of about 0.3 mm, for example.

In the fourth embodiment, the second banks 90x are each located at the distal portions 31b of the respective raised curved portions 31, and formed integrally with the sheet member 90. The second banks 90x prevent creation of stagnation (stagnation points) of the coolant 40 near the respective lowered curved portions 32, and correspond to the second stagnation preventing member of the present invention. The second bank 90x has a shape like a generally vertical half of a taper, tapering toward the plate 10 (left side in FIG. 18). Since other configurations of the fourth embodiment are similar to the configurations of the first embodiment, the description will be omitted.

The advantageous effects of the fourth embodiment will be described. In the fourth embodiment, since the gap SM is filled up with the sheet member 90 as shown in FIG. 18, the coolant 40 can be prevented from flowing into the gap SM. This prevents the main stream MS of the coolant 40 from slowing down, whereby the heat transfer coefficient of the wavy fins 30 can be improved. Moreover, the banks 31x and the second banks 90x create flows of the coolant 40 from the raised curved portions 31 toward the opposite lowered curved portions 32. Thereby, the main stream MS of the coolant 40 that tends to flow straight can be mixed substantially with the coolant 40 stagnating near the lowered curved portions 32, whereby the heat transfer coefficient of the wavy fins 30 can be largely improved.

The cost, however, is higher with the cooler 4C of the fourth embodiment because of the sheet member 90 being added as another component, as compared to the cooler 4 of the first embodiment. The pressure fluctuations of the coolant 40 are larger since the space for the coolant 40 to flow in is reduced by the second banks 90. The pressure loss of the cooler 4C of the fourth embodiment is, therefore, larger than that of the cooler 4 of the first embodiment. Since other advantageous effects of the fourth embodiment are similar to the advantageous effects of the first embodiment, the description will be omitted.

While coolers according to the present invention have been described above, the present invention is not limited to these and can be modified in various manners without departing from the subject matter. In the first embodiment, for example, the banks 31x are integrally formed to the respective raised curved portions 31 by casting. Alternately, the banks 31x may be separate from the plate 10 and may be joined to the raised curved portions 31 by welding or bonding. In the first embodiment, the banks 31x are provided at the base portions 31a of the raised curved portions 31. Alternately, the banks 31x may be provided at other portions than the base portions 31a of the raised curved portions 31, for example at the distal portions 31b of the raised curved portions 31. The shape and the size of the banks 31x may be changed as required.

In the second embodiment, one protrusion 31y is provided on each raised curved portion 31. Alternately, a plurality of protrusions 31y may be provided on each raised curved portion 31. For example, two protrusions 31y may be provided at the base portion 31a of the raised curved portion 31. Alternatively, one protrusion 31y may be provided at the base portion 31a of the raised curved portion 31, and another protrusion 31y may be provided at the distal portion 31b of the raised curved portion 31. The shape and the size of the protrusions 31y can be changed as required.

In the third embodiment, the banks 31x are provided at the base portions 31a of the raised curved portions 31, while the second banks 21x are provided at the distal portions 31b of the raised curved portions 31. Alternately, protrusions may be provided at the base portions 31a of the raised curved portions 31 instead of the banks 31x. Alternatively, protrusions may be provided at the distal portions 31b of the raised curved portions 31 instead of the second banks 21 x.

In the forth embodiment, the second banks 90x are provided on the sheet member 90. Alternately, protrusions may be provided on the sheet member 90.

In each embodiment mentioned above, the distance (flow path width) of the adjacent wavy fins 30 is made constant at any points in the flowing direction, but it may be changed at any points in the flowing direction.

### Reference Signs List

- 1: Inverter device
- 2: Semiconductor device
- 3: Insulating substrate
- 4, 4A, 4B, 4C: Cooler
- 10: Plate
- 20: Cooling case
- 21: Bottom wall
- 21x: Second bank
- 30: Wavy fin
- 31: Raised curved portion
- 31a: Base portion
- 31b: Distal portion
- 31x: Bank
- 31y: Protrusion
- 32: Lowered curved portion
- 40: Coolant
- 90: Sheet member
- 90x: Second bank

## Claims

1. A cooler including:
a plate connected to a semiconductor device;
a cooling case covered with the plate and having a coolant flowing therein; and
wavy fins connected to the plate, each wavy fin having a raised curved portion and a lowered curved portion formed alternately on a side face of the wavy fin in a flow direction of the coolant, the coolant flowing through between the raised curved portion and the lowered curved portion opposite to each other in a meandering manner,
wherein the raised curved portion is provided with a stagnation preventing member for creating a flow of coolant from the raised curved portion toward the opposite lowered curved portion.

2. The cooler according to claim 1, wherein the stagnation preventing member is provided at a base portion of the raised curved portion on a semiconductor device side in a thickness direction of the wavy fins.

3. The cooler according to claim 1 or 2, wherein the stagnation preventing member is a tapered bank tapering toward a bottom wall of the cooling case.

4. The cooler according to claim 1 or 2, the stagnation preventing member is a protrusion protruding from the raised curved portion toward the opposite lowered curved portion.

5. The cooler according to any one of claims 1 to 4, wherein a second stagnation preventing member for creating a flow of coolant from the raised curved portion toward the opposite lowered curved portion is provided, the second stagnation preventing member being positioned at a distal portion of the raised curved portion on a side of the bottom wall of the cooling case in a thickness direction of the wavy fins.
